# EUROPÄISCHE PATENTSCHRIFT

(11) **EP 3 016 799 B1**
(45) Veröffentlichungstag und Bekanntmachung des Hinweises auf die Patenterteilung: **20.05.2020**
(21) Anmeldenummer: 14732557.5
(22) Anmeldetag: 24.06.2014
(51) Int. Cl.: H01M 2/10, B29C 63/04

(54) **VERFAHREN ZUM HERSTELLEN EINES GEHÄUSES MIT EINER SCHIRMUNG VOR ELEKTRISCHER UND/ODER MAGNETISCHER STRAHLUNG UND GEHÄUSE MIT SCHIRMUNG VOR ELEKTRISCHER UND/ODER MAGNETISCHER STRAHLUNG**
METHOD FOR PRODUCING A HOUSING HAVING SHIELDING AGAINST ELECTRIC AND/OR MAGNETIC RADIATION, AND HOUSING HAVING SHIELDING AGAINST ELECTRIC AND/OR MAGNETIC RADIATION
PROCÉDÉ DE FABRICATION D'UN BOÎTIER ÉQUIPÉ D'UN BLINDAGE ANTI-RAYONNEMENT ÉLECTRIQUE ET/OU MAGNÉTIQUE ET BOÎTIER ÉQUIPÉ D'UN BLINDAGE ANTI-RAYONNEMENT ÉLECTRIQUE ET/OU MAGNÉTIQUE

(30) Priorität: 05.07.2013 DE 102013213233
(43) Veröffentlichungstag der Anmeldung: 11.05.2016
(73) Patentinhaber: Bayerische Motoren Werke Aktiengesellschaft, 80809 München (DE)
(72) Erfinder: BEN SALAH, Semi, 85464 Finsing (DE); MINEIF, Harald, 80637 München (DE); RÄTTICH, Philip, 80336 München (DE); WAGNER, Matthias, 80805 München (DE)
(86) Internationale Anmeldenummer: PCT/EP2014/063276
(87) Internationale Veröffentlichungsnummer: WO 2015/000743

(56) Entgegenhaltungen:
- EP-A1- 1 933 609
- FI-A- 940 803
- JP-A- H0 831 969
- JP-A- 2000 101 277
- US-A1- 2011 234 096

## Beschreibung

Die vorliegende Erfindung betrifft ein Verfahren zum Herstellen eines Gehäuses mit einer Schirmung vor elektrischer und/oder magnetischer Strahlung. Des Weiteren betrifft die Erfindung ein Gehäuse mit Schirmung vor elektrischer und/oder magnetischer Strahlung sowie einen Hochvoltspeicher mit Schirmung vor elektrischer und/oder magnetischer Strahlung.

Aus der EP1933609 ist ein gattungsgemäßes Verfahren und ein entsprechendes Gehäuse bekannt.

Eine elektrische Vorrichtung kann eine elektrische Einrichtung und ein Gehäuse, das die elektrische Einrichtung zum Schutz umgibt, aufweisen. Zur Gewährleistung eines einwandfreien Betriebs der elektrischen Einrichtung ist es bei zahlreichen elektrischen Vorrichtungen notwendig, dass das Gehäuse die elektrische Einrichtung vor elektromagnetischer Strahlung abschirmt. Zu solchen elektrischen Vorrichtungen gehören beispielsweise Hochvoltspeicher, die in Fahrzeugen mit Elektroantrieb zum Bereitstellen der elektrischen Energie vorgesehen sind.

Zur EMV-Schirmung einer elektrischen Vorrichtung, beispielsweise eines Hochvoltspeichers, kann die Vorrichtung ein metallisches und damit elektrisch leitfähiges Gehäuse aufweisen. Falls eine elektrische Einrichtung von einem elektrisch nichtleitenden Gehäuse, beispielsweise einem Kunststoffgehäuse, umgeben ist, müssen an dem Gehäuse zusätzliche Maßnahmen vorgesehen werden, sodass das Gehäuse trotz seines elektrisch nichtleitenden Grundmaterials elektrisch leitfähig ist.

Auf die Oberfläche eines elektrisch nichtleitfähigen Gehäuses können beispielsweise leitende EMV-Lacke aufgebracht werden. Des Weiteren können in das nichtleitende Basismaterial des Gehäuses EMV-Gewebe oder leitfähige Vliese eingelegt werden. Darüber hinaus besteht die Möglichkeit, dem elektrisch nichtleitfähigen Grundmaterial, beispielsweise einem Kunststoffmaterial, eines Gehäuses Füllstoffe beizumischen, die elektrisch leitend sind.

Eine solche Schirmung kann jedoch leicht beschädigt werden. Des Weiteren ergeben sich durch die genannten Maßnahmen oftmals nur schlechte Schirmeigenschaften. Es gelingt vielfach nicht, eine homogene Leitfähigkeit des Gehäuses sicherzustellen. Darüber hinaus können die geforderten mechanischen Eigenschaften des Gehäuses nachteilig beeinflusst werden. Gewebe, Fliese oder EMV-Lacke erfordern meistens eine manuelle Aufbringung, so dass eine Großserientauglichkeit nicht gegeben ist. Die Verfahren sind insgesamt sehr aufwändig und mit hohen Kosten verbunden.

Es ist daher wünschenswert, ein Verfahren zum Herstellen eines Gehäuses mit einer Schirmung vor elektrischer und/oder magnetischer Strahlung anzugeben, durch das auf einfache und zuverlässige Weise eine Schirmung einer elektrischen Einrichtung vor elektrischer und/oder magnetischer Strahlung gewährleistet ist. Des Weiteren soll ein Verfahren zum Herstellen eines Hochvoltspeichers mit einer Schirmung vor elektrischer und/oder magnetischer Strahlung angegeben werden, durch das auf einfache und zuverlässige Weise eine Schirmung des Hochvoltspeichers vor elektrischer und/oder magnetischer Strahlung gewährleistet ist. Weiterhin besteht ein Bedarf, ein Gehäuse mit Schirmung vor elektrischer und/oder magnetischer Strahlung anzugeben, durch das eine elektrische Einrichtung auf einfache und zuverlässige Weise vor elektrischer und/oder magnetischer Strahlung abgeschirmt werden kann. Darüber hinaus soll ein Hochvoltspeicher mit Schirmung vor elektrischer und/oder magnetischer Strahlung angegeben werden, der auf zuverlässige und einfache Weise vor elektrischer und/oder magnetischer Strahlung geschützt ist.

Ein Verfahren zum Herstellen eines Gehäuses mit einer Schirmung vor elektrischer und/oder magnetischer Strahlung ist im Patentanspruch 1 angegeben. Das Verfahren sieht das Bereitstellen einer elektrisch und/oder magnetisch leitfähigen Folie sowie das Bereitstellen eines Gehäuses aus einem elektrisch und/oder magnetisch nichtleitfähigen Material mit einer äußeren und einer inneren Wandung vor. Die Folie wird derart geformt, dass eine Form der Folie einer Form der äußeren oder inneren Wandung des Gehäuses entspricht. Die Folie wird auf der äußeren oder inneren Wandung des Gehäuses angeordnet.

Die Folie kann aus ihrer ursprünglichen Gestalt beispielsweise mittels eines Formwerkzeugs umgeformt werden, indem die Folie nach dem Einlegen in das Formwerkzeug an eine Wandung des Formwerkzeugs gepresst wird. Die Wandung des Formwerkzeugs ist dazu invers zu der Form des Gehäuses aus dem elektrisch und/oder magnetisch nichtleitfähigen Material, an dem die Folie befestigt wird, ausgestaltet. Mittels eines weiteren Formwerkzeugs, das wiederum invers zu dem Formwerkzeug geformt ist, wird die Folie gegen die Wandung des Formwerkzeugs gedrückt und dadurch derart umgeformt, dass sie nach dem Pressen gegen die Wandung des Formwerkzeugs zur Überdeckung des Gehäuses beziehungsweise zur inneren Auskleidung des Gehäuses geeignet ausgebildet ist.

Während des Andrückens der Folie an die Wandung des Formwerkzeugs kann die Folie von ihren Seitenrändern her in das Formwerkzeug nachgeführt werden. Die beim Andrücken der Folie an die Wandung des Formwerkzeugs entstehenden Falten können bei dem Umformverfahren in der benötigten Geometrie verpresst werden. Nach der Umformung der Folie kann die vorgeformte Folie auf das elektrisch und/oder magnetisch nichtleitfähige Gehäuse aufgebracht werden. Die Folie kann beispielsweise durch Heißsiegeln, Kleben oder durch Verschrauben auf der äußeren oder inneren Wandung des Gehäuses angebracht werden.

Gemäß des Verfahrens kann die Folie mit ihrer ursprünglichen Form in das Formwerkzeug eingelegt und an die Wandung des Formwerkzeugs angedrückt werden, sodass die Wandung des Formwerkzeugs mit der Folie ausgekleidet ist. Anschließend kann die Folie mit dem elektrisch nichtleitfähigen Material des Gehäuses hinterspritzt werden. Gemäß einer möglichen Ausführungsform kann auf eine Oberfläche des weiteren Formwerkzeugs, das zu dem Formwerkzeug, dessen Wandung die Folie auskleidet, invers geformt ist, das elektrisch und/oder magentisch nichtleitfähige Material des Gehäuses aufgebracht werden. Bei einem Gehäuse aus Kunststoff kann zum Beispiel eine Kunststoffmasse auf die Oberfläche des weiteren Formwerkzeugs aufgebracht werden. Das elektrisch nichtleitfähige Material wird gegen die an der Wandung des Formwerkzeugs anliegende Folie gepresst. Dadurch können die Folie und das elektrisch nichtleitfähige Material des Gehäuses unmittelbar miteinander verbunden werden. Eine Ausführungsform eines Verfahrens zum Herstellen eines Hochvoltspeichers mit einer Schirmung vor elektrischer und/oder magnetischer Strahlung ist im Patentanspruch 10 angegeben. Das Verfahren sieht das Herstellen eines Gehäuses mit einer Schirmung vor elektrischer und/oder magnetischer Strahlung nach einer der oben genannten Ausführungsformen vor. Gemäß dem Verfahren wird ein weiteres Gehäuse aus einem elektrisch und/oder magnetisch leitfähigen Material bereitgestellt, wobei ein Ladungsspeicher des Hochvoltspeichers von dem weiteren Gehäuse umgeben ist. Das Gehäuse mit der Schirmung vor elektrischer und/oder magnetischer Strahlung wird als Deckel des Hochvoltspeichers auf dem weiteren Gehäuse angeordnet. Damit ist der Ladungsspeicher des Hochvoltspeichers auf einfache und zuverlässige Weise vor elektrischer und/oder magnetischer Strahlung geschützt.

Im Patentanspruch 11 ist ein Gehäuse mit Schirmung vor elektrischer und/oder magnetischer Strahlung angegeben. Gemäß einer Ausführungsform umfasst das Gehäuse eine elektrisch und/oder magnetisch leitfähige Folie. Das Gehäuse ist aus elektrisch und/oder magnetisch nichtleitfähigem Material ausgebildet und weist eine äußere und innere Wandung auf. Die Folie ist derart ausgestaltet, dass eine Form der Folie einer Form der äußeren oder inneren Wandung des Gehäuses entspricht. Die Folie ist auf der äußeren oder inneren Wandung des Gehäuses angeordnet. Das Gehäuse mit Schirmung vor elektrischer und/oder magnetischer Strahlung und insbesondere die Folie des Gehäuses sind nach einer der Ausführungsformen des oben beschriebenen Verfahrens hergestellt.

In Patentanspruch 12 ist ein Hochvoltspeicher mit Schirmung vor elektrischer und/oder magnetischer Strahlung spezifiziert. Der Hochvoltspeicher umfasst ein Gehäuse nach einer der oben genannten Ausführungsformen sowie ein weiteres Gehäuse aus einem elektrisch und/oder magnetisch leitfähigen Material. Des Weiteren umfasst der Hochvoltspeicher einen Ladungsspeicher, der in dem weiteren Gehäuse angeordnet ist.

Das Gehäuse ist an dem weiteren Gehäuse derart angeordnet, dass der Ladungsspeicher von dem Gehäuse abgedeckt ist. Aufgrund der Kapselung des Ladungspeichers durch das Gehäuse mit der elektrisch und/oder magnetisch leitfähigen Folie und das weitere Gehäuse aus dem elektrisch und/oder magnetisch leitfähigen Material ist der Ladungsspeicher des Hochvoltspeichers vor elektrischer und/oder magnetischer Strahlung geschirmt.

Die Erfindung wird im Folgenden anhand von Figuren, die Ausführungsbeispiele der vorliegenden Erfindung zeigen, näher erläutert. Es zeigen:
- Figur 1: eine Ausführungsform einer Folie aus einem elektrisch und/oder magnetisch leitfähigem Material vor einer Umformung,
- Figur 2: eine Ausführungsform einer elektrischen Vorrichtung mit Schirmung vor elektrischer und/oder magnetischer Strahlung,
- Figur 3: eine weitere Ausführungsform einer elektrischen Vorrichtung mit Schirmung vor elektrischer und/oder magnetischer Strahlung,
- Figur 4: eine Verbindung zweier Gehäuse zur Schirmung einer elektrischen Einrichtung vor elektrischer und/oder magnetischer Strahlung,
- Figur 5A: einen Schritt einer Ausführungsform eines Verfahrens zum Herstellen eines Gehäuses mit einer Schirmung vor elektrischer und/oder magnetischer Strahlung,
- Figur 5B: einen weiteren Schritt einer Ausführungsform eines Verfahrens zum Herstellen eines Gehäuses mit einer Schirmung vor elektrischer und/oder magnetischer Strahlung,
- Figur 5C: eine Ausführungsform einer Folie mit Schirmung vor elektrischer und/oder magnetischer Strahlung,
- Figur 6A: einen Schritt einer weiteren Ausführungsform eines Verfahrens zum Herstellen eines Gehäuses mit einer Schirmung vor elektrischer und/oder magnetischer Strahlung,
- Figur 6B: einen weiteren Schritt einer weiteren Ausführungsform eines Verfahrens zum Herstellen eines Gehäuses mit einer Schirmung vor elektrischer und/oder magnetischer Strahlung,
- Figur 6C: einen weiteren Schritt einer weiteren Ausführungsform eines Verfahrens zum Herstellen eines Gehäuses mit einer Schirmung vor elektrischer und/oder magnetischer Strahlung,
- Figur 6D: eine Ausführungsform eines Gehäuses mit Schirmung vor elektrischer und/oder magnetischer Strahlung.

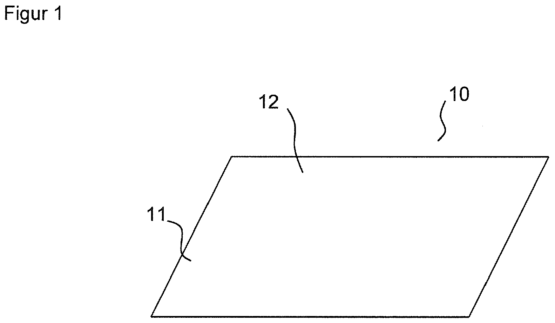

Figur 1 zeigt eine Ausführungsform einer Folie 10 aus einem elektrisch und/oder magnetisch leitfähigen Material. Die Folie kann beispielsweise aus Aluminium als elektrisch leitfähigem Material ausgebildet sein. Die Folie kann auch beispielsweise als eine Stahlblechfolie ausgestaltet sein. Bei dieser Ausführungsform weist die Folie elektrisch und zusätzlich magnetisch leitfähige Eigenschaften auf. Die Folie kann zunächst als eine ebene Lage einer Materialbahn bereitgestellt werden. Die Folie kann auf zumindest einer ihrer Seiten eine Klebstoffbeschichtung 11 oder eine Kunststoffbeschichtung 12, beispielsweise eine Beschichtung aus PP (Polypropylen), aufweisen.

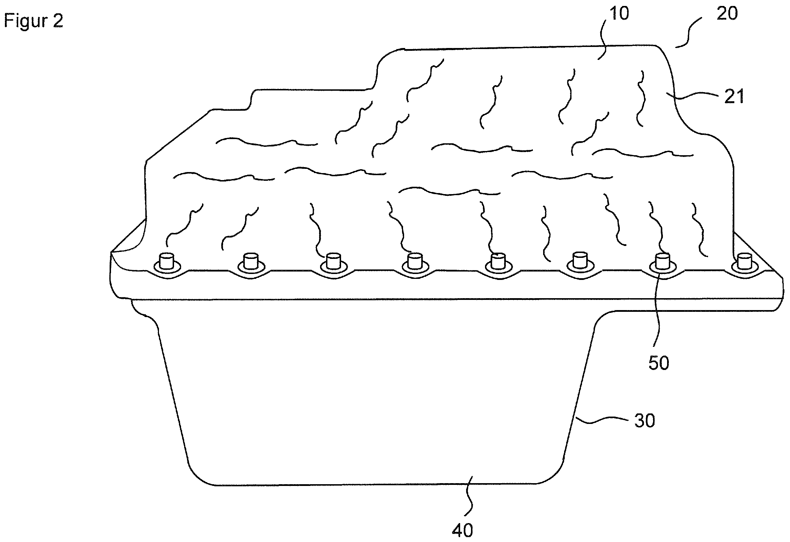

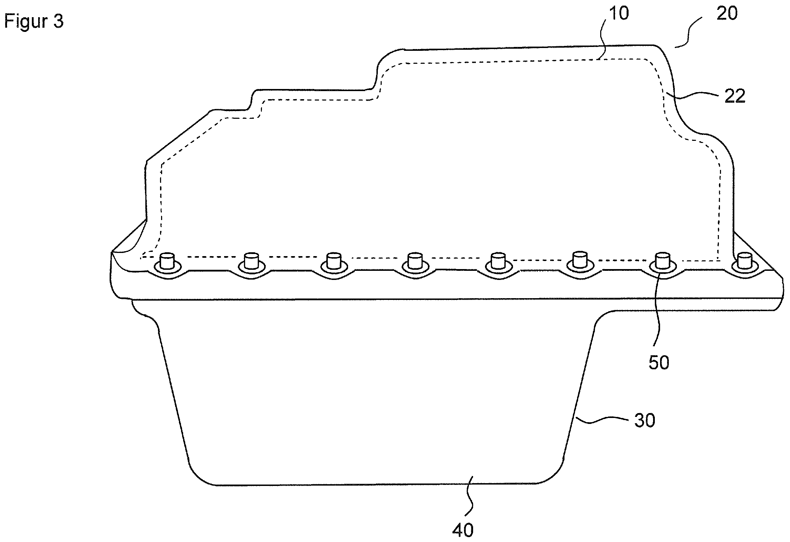

Die Figuren 2 und 3 zeigen verschiedene Ausführungsformen einer elektrischen Vorrichtung 1 mit einer Schirmung vor elektrischer und/oder magnetischer Strahlung. Die elektrische Vorrichtung 1 kann beispielsweise als ein Hochvoltspeicher ausgebildet sein. Die elektrische Vorrichtung weist eine elektrisch und/oder magnetisch leitfähige Folie 10, ein Gehäuse 20 aus einem elektrisch und/oder magnetisch nichtleitfähigem Material, ein Gehäuse 30 aus einem elektrisch und/oder magnetisch leitfähigem Material sowie mindestens eine elektrische Einrichtung 40 auf. Wenn die elektrische Vorrichtung 1 als ein Hochvoltspeicher ausgebildet ist, kann die elektrische Einrichtung beispielsweise ein Ladungsspeicher sein.

Die mindestens eine elektrische Einrichtung 40 ist in dem Gehäuse 30 angeordnet. Aufgrund der elektrisch und/oder magnetisch leitfähigen Materialeigenschaften des Gehäuses 30 ist die mindestens eine elektrische Einrichtung 40 durch das Gehäuse 30 bereits teilweise vor elektrischer und/oder magnetischer Strahlung geschützt. Das Gehäuse 30 schützt die mindestens eine elektrische Einrichtungen 40 zumindest an der Unterseite und teilweise von der Seite her vor elektrischer und/oder magnetischer Strahlung.

Um die mindestens eine elektrische Einrichtung 40 auch von der Oberseite her vor elektrischer und/oder magnetischer Strahlung zu schützen, ist an dem Gehäuse 20 aus dem elektrisch und/oder magnetisch nichtleitfähigen Material die Folie 10 aus dem elektrisch und/oder magnetisch leitfähigen Material angeordnet. Das Gehäuse 20 kann beispielsweise ein Material aus Kunststoff enthalten und die Folie 10 kann, wie bereits im Zusammenhang mit Figur 1 erläutert, als eine Aluminium- oder Stahlblechfolie ausgebildet sein.

Bei der in Figur 2 gezeigten Ausführungsform einer elektrischen Vorrichtung 1 ist die Folie 10 an einer äußeren Wandung 21 des Gehäuses 20 angeordnet ist. Die Folie 10 ist dazu ausgehend von ihrer ursprünglichen in Figur 1 gezeigten Form derart umgeformt, dass die Form der Folie 10 einer Form der äußeren Wandung 21 des Gehäuses 20 entspricht. Bei der klebstoffbeschichteten Ausführungsform der Folie 10 kann die Folie auf die äußere Wandung 21 des Gehäuses 20 aufgeklebt sein. Wenn die Folie 10 mit der Kunststoffbeschichtung 12 versehen ist, kann die Folie 10 auf die äußere Wandung 21 des Gehäuses 20 angesiegelt werden. Nach dem Umformen der Folie 10 kann die Folie mit ihrer kunststoffbeschichteten Seite auf die äußere Wandung 21 aufgelegt werden. Die Folie 10 wird anschließend durch Heißsiegeln mit der äußeren Wandung 21 des Gehäuses 20 verbunden. Dazu wird die Folie 10 erwärmt, sodass die Kunststoffbeschichtung 12 aufschmilzt und sich mit der äußeren Wandung 21 des Gehäuses 20 verbindet.

Bei der in Figur 3 gezeigten Ausführungsform der elektrischen Vorrichtung 1 ist die Folie 10 auf einer inneren Wandung 22 des Gehäuses 20 angeordnet. Die innere Wandung 22 des Gehäuses 20 ist somit mit der Folie 10 ausgekleidet. Die Folie 10 kann dazu an einer Seite beispielsweise die in Figur 1 gezeigte Klebstoffbeschichtung 11 aufweisen und mittels der Klebstoffbeschichtung gegen die innere Wand 22 des Gehäuses 20 geklebt sein. Gemäß einer weiteren möglichen Ausführungsform kann die Folie 10 an die innere Wandung 22 des Gehäuses 20 angesiegelt sein. Die Folie 10 kann beispielsweise die Kunststoffbeschichtung 12 aufweisen und nach dem Verformen durch Heißsiegeln mit der inneren Wandung 22 des Gehäuses 20 verbunden sein. Dazu kann die Folie 10 zunächst verformt werden, so dass sie bereits die Form der inneren Wandung 22 aufweist. Anschließend wird die Folie 10 in das Innere des Gehäuses 10 eingelegt. Durch nachfolgendes Erwärmen und Aufschmelzen der Kunststoffbeschichtung 12 kann die Folie 10 mit der inneren Wandung 22 des Gehäuses 20 verbunden werden.

Bei den in den Figuren 2 und 3 gezeigten Ausführungsformen der elektrischen Vorrichtung 1 übernimmt einerseits das Gehäuse 30 aus dem elektrisch und/oder magnetisch leitfähigen Material und andererseits das Gehäuse 20 zusammen mit der Folie 10 aus dem elektrisch und/oder magnetisch leitfähigen Material die Schirmung der mindestens einen elektrischen Einrichtung 40 vor elektrischer und/oder magnetischer Strahlung. Das elektrisch und/oder magnetisch leitfähige Gehäuse 30 kann beispielsweise ein metallisches Gehäuse sein. Dadurch kann die mindestens eine elektrische Einrichtung 40 kostengünstig vor elektrischer und/oder magnetischer Strahlung geschützt werden.

Da die Folie 10 sehr dünn, beispielsweise mit einer Materialstärke zwischen 0,2 mm und 1 mm, ausgebildet sein kann, ermöglicht das mit der Folie 10 überdeckte Gehäuse 20 beziehungsweise das mit der Folie 10 ausgekleidete Gehäuse 20 gegenüber der Verwendung eines metallischen Deckels einen vollwertigen Schutz vor elektrischer und/oder magnetischer Strahlung bei gleichzeitiger Gewichtsreduktion. Durch das Fixieren der elektrisch und/oder magnetisch leitfähigen Folie 10 auf einem Kunststoffmaterial des Gehäuses 20, ermöglicht die Konstruktion Kunststoffgehäuseteile mit EMV-Schutzeigenschaften bereitzustellen. Des Weiteren weist das Gehäuse 20 mit der elektrischen und/oder magnetischen Schirmung durch die Folie 10 bessere Schirmdämpfungseigenschaften auf, als dies durch Beschichtung des Gehäuses 20 mit leitenden EMV-Lacken oder durch die Verwendung von in das Gehäuse 20 eingelegten EMV-Geweben oder leitfähigen Vliesen möglich wäre.

Über die Wahl des Folienmaterials ist die Schirmung skalierbar. Bei Verwendung eines elektrisch leitfähigen Materials für die Folie 10 kann beispielsweise ein Gehäuse mit einer rein elektrischen Schirmung bereitgestellt werden. Hierzu kann die Folie 10 beispielsweise als Folie aus Aluminium ausgebildet sein. Bei Verwendung einer Folie aus einem elektrisch und magnetisch leitfähigen Material, beispielsweise bei Verwendung einer Stahlblechfolie, kann das Gehäuse 20 in Kombination mit dieser Folie sowohl elektrische als auch magnetische Schirmeigenschaften aufweisen.

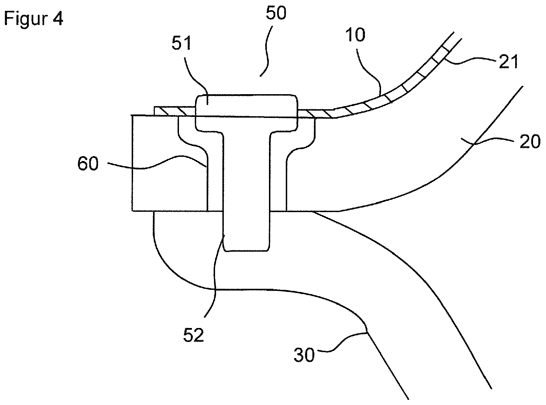

Figur 4 zeigt eine weitere Ausführungsform der Befestigung der Folie 10 an dem Gehäuse 20. Gemäß der in Figur 4 gezeigten Alternative wird das mit der Folie 10 überzogene Gehäuseteil 20, beispielsweise ein glasfaserverstärktes Kunststoffteil, mit dem elektrisch und/oder magnetisch leitfähigen Gehäuse 30, beispielsweise mit einem metallischen Gehäuse, verschraubt. Dazu können die aufeinander liegenden Ränder der Gehäuse 20 und 30 in Abhängigkeit von der Zahl der vorzusehenden Schrauben 50 Löcher zur Aufnahme der Schrauben 50 aufweisen. In den Löchern können Buchsen 60 vorgesehen sein. Bei der Variante, bei der die Folie 10 auf einer äußeren Wandung 21 des Gehäuses 20 angeordnet ist, ist die Folie derart geformt, dass Teile der Folie 10 über den Löchern zur Aufnahme der Schrauben liegen. Beim Verschrauben der beiden Gehäuseteile 20 und 30 wird gleichzeitig die Folie 10 an der äußeren Wandung 21 des Gehäuses 20 fixiert. Die Fixierung erfolgt beispielsweise mittels eines jeweiligen Schraubenkopfes 51 der Schrauben 50. Der Durchmesser des Schraubenkopfes 51 kann dazu beispielsweise mindestens doppelt so groß sein wie der Durchmesser des Gewindes 52 der Schrauben. Beim Andrehen der Schrauben wird die Folie 10 durch die Schraubenköpfe 51 an dem Gehäuse 20 geklemmt und dadurch an dem Gehäuse 20 fixiert.

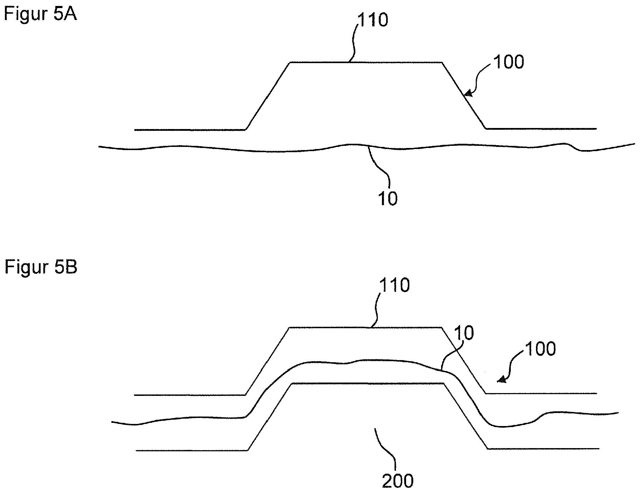

Die Figuren 5A und 5B zeigen eine mögliche Ausführungsform eines Verfahrens zum Formen der Folie 10 beziehungsweise zum Herstellen des Gehäuses 20 mit einer Schirmung vor elektrischer und/oder magnetischer Strahlung. Dazu wird zunächst die in Figur 1 gezeigte Folie 10 aus dem elektrisch und/oder magnetisch leitfähigen Material als ebene Materialbahn bereitgestellt. Des Weiteren wird das Gehäuse 20 aus dem elektrisch und/oder magnetisch nichtleitfähigen Material mit der äußeren Wandung 21 beziehungsweise der inneren Wandung 22 bereitgestellt. Die Folie 10 wird nun derart geformt, dass eine Form der Folie 10 einer Form der äußeren Wandung 21 oder einer Form der inneren Wandung 22 des Gehäuses 20 entspricht. Nachfolgend wird die Folie 10, wie in Figur 2 gezeigt, auf der äußeren Wandung 21 des Gehäuses 20 oder, wie in Figur 3 gezeigt, auf der inneren Wandung 22 des Gehäuses 20 angeordnet. Das Aufbringen der umgeformten Folie 10 auf das Gehäuse 20 kann mittels Kleben, Heißsiegeln oder Verschrauben erfolgen.

Zum Formen der Folie 10 kann ein Formwerkzeug 100 mit einer Wandung 110, deren Form der äußeren Wandung 21 des Gehäuses 20 oder deren Form der inneren Wandung 22 des Gehäuses 20 entspricht, bereitgestellt werden. Wie in Figur 5A gezeigt, wird die Folie 10 in das Formwerkzeug 100 eingelegt. Anschließend erfolgt das Umformen der Folie 10 in dem Formwerkzeug 100 durch Andrücken beziehungsweise Anpressen der Folie 10 an die Wandung 110 des Formwerkzeugs 100.

Figur 5B zeigt diesen Umformungsprozess. Dazu wird ein weiteres Formwerkzeug 200 bereitgestellt, das zu der Wandung 110 des Formwerkzeugs 100 invers geformt ist. Die Folie 10 wird an die Wandung 110 des Formwerkzeugs 100 angedrückt, indem das weitere Formwerkzeug 200, beispielsweise ein Stempel, gegen die Wandung 110 des Formwerkzeugs 100 gedrückt wird. Die Folie 10, die zwischen dem Formwerkzeug 100 und dem weiteren Formwerkzeug 200 angeordnet ist, wird dadurch gegen die Wandung 110 des Formwerkzeugs 100 gepresst und entsprechend der Form des Formwerkzeugs 100 geformt.

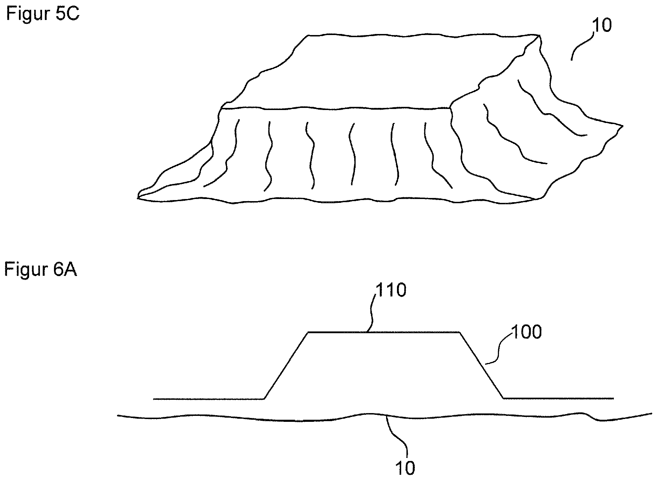

Figur 5C zeigt die im Vergleich zu Figur 1 nunmehr umgeformte Folie 10 nach der Entnahme aus dem Formwerkzeug 100. Beim Anpressen der Folie 10 an die Wandung 110 des Formwerkzeugs 100 mittels des weiteren Formwerkzeugs 200 wird die Folie 10 seitlich in das Formwerkzeug 100 nachgeführt, sodass beim Verpressen genügend Folienmaterial für die Umformung zur Verfügung steht. Dadurch weist die in Figur 5C gezeigte umgeformte Folie 10 keine Risse, sondern lediglich lokale Falten 13 auf. Bei Verwendung eines geeigneten Formwerkzeugs 200 können die Falten 13 durch Verpressen der Folie 10 an die Wandung 110 des Formwerkzeugs 100 glattgepresst werden, sodass die umgeformte Folie 10 nach der Entnahme eine nahezu ebene Oberfläche beziehungsweise zumindest keine hochstehenden Falten mehr aufweist.

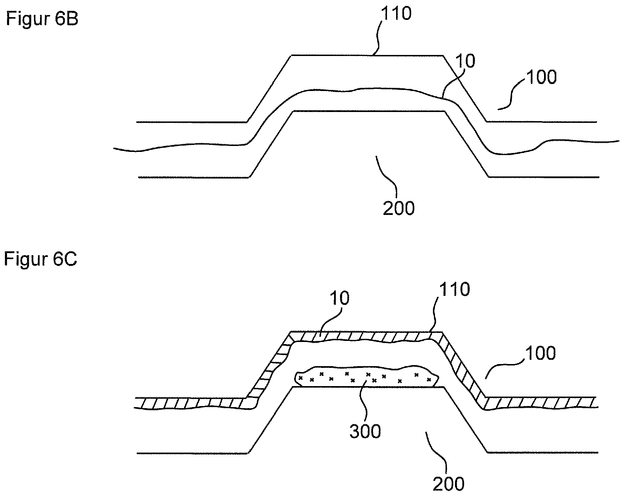

Die Figuren 6A, 6B und 6C zeigen eine weitere mögliche Ausführungsform eines Verfahrens zum Formen der Folie 10 beziehungsweise zum Herstellen eines Gehäuses mit einer Schirmung vor elektrischer und/oder magnetischer Strahlung. Zunächst wird auch bei diesem Verfahren eine elektrisch und/oder magnetisch leitfähige Folie 10 sowie ein Gehäuse 20 aus einem elektrisch und/oder magnetisch nichtleitfähigen Material mit einer äußeren Wandung 21 und einer inneren Wandung 22 bereitgestellt. Die Folie 10 wird mittels dem in den Figuren 6A, 6B und 6C gezeigten Verfahren nunmehr derart geformt, dass eine Form der Folie 10 einer Form der äußeren Wandung 21 des Gehäuses 20 oder der inneren Wandung 22 des Gehäuses 20 entspricht. Nach dem Umformen der Folie 10 wird die umgeformte Folie auf der äußeren Wandung 21 oder der inneren Wandung 22 des Gehäuses 20 fixiert. Die Fixierung kann mittels Kleben, Heißsiegeln oder Verschrauben erfolgen.

Auch bei dem in den Figuren 6A bis 6C gezeigten Verfahren wird ein Formwerkzeug 100 mit einer Wandung 110, deren Form der äußeren Wandung 21 beziehungsweise deren Form der inneren Wandung 22 des Gehäuses 20 entspricht, bereitgestellt. Wie in Figur 6A gezeigt, wird die Folie 10 in das Formwerkzeug 100 eingelegt. Danach erfolgt das Umformen der Folie 10 in dem Formwerkzeug 100 durch Andrücken der Folie 10 an die Wandung 110 des Formwerkzeugs 100. Dazu kann, wie in Figur 6B dargestellt, ein weiteres Formwerkzeug 200 bereitgestellt werden, das zu der Wandung 110 des Formwerkzeugs 100 invers geformt ist. Die Folie 10 wird mittels des weiteren Formwerkzeugs 200 durch Andrücken an die Wandung 110 des Formwerkzeugs 100 gepresst. Die Folie 10 ist dazu zwischen der Wandung 110 des Formwerkzeugs 100 und dem weiteren Formwerkzeug 200, beispielsweise einem Stempel des Formwerkzeugs 200, angeordnet. Um das Auftreten von Rissen zu vermeiden, wird die Folie 10 während des Pressvorgangs seitlich in das Formwerkzeug 100 nachgeschoben.

Nach dem Verpressen liegt der Folie 10 formschlüssig an der Wandung 110 des Formwerkzeugs 100 an. In einem nachfolgenden in Figur 6C gezeigten Verfahrensschritt wird nun das Material, aus dem das Gehäuse 20 geformt wird, auf der Folie 10 angeordnet beziehungsweise mit der Folie 10 unmittelbar verbunden. Die Folie 10 kann dazu mit dem elektrisch und/oder magnetisch nichtleitfähigen Material des Gehäuses 20, beispielsweise einem Kunststoffmaterial, hinterspritzt werden.

Bei der in Figur 6C gezeigten Ausführungsform wird das elektrisch und/oder magnetisch nichtleitfähige Material des Gehäuses 20, beispielsweise eine Kunststoffmasse, auf einer Oberfläche des weiteren Formwerkzeugs 200 aufgebracht. Das weitere Formwerkzeug 200 mit dem elektrisch und/oder magnetisch nichtleitfähigen Material wird anschließend gegen die Wandung 110 des Formwerkzeugs 100 mit der vorgeformten Folie 10 gepresst. Beim Verpressen verläuft die Materialmasse des Gehäuses 20 auf der Oberfläche der Folie 10 und verbindet sich infolge des Verpressens unmittelbar mit der Folie 10. Eine Verklebung, ein Heißsiegeln oder eine Verschraubung zum Fixieren der Folie 10 auf dem Gehäuse 20 ist nicht erforderlich.

Die Folie 10 kann bei dem Verfahren des Hinterspritzens als auch bei dem in Figur 6C gezeigten Verfahren des Pressens mit Hilfe von Nadelhaltern oder mit Hilfe eines Unterdrucks, der durch Unterdruckkanäle, die in einem der Formwerkzeuge 100 beziehungsweise 200 vorgesehen sein können, an einer Oberals auch einer Unterseite der Formwerkzeuge fixiert werden. Um zu verhindern, dass bei dem Hinterspriten oder dem Verpressen mit dem weiteren Formwerkzeug 200 Lufteinschlüsse auftreten, kann die Folie 10 perforiert sein. Bei gleichzeitigem Einlegen der Buchsen oder anderer Verbindungselemente kann die Folie 10 von den Buchsen an dem Material des Gehäuses 20 im Formwerkzeug fixiert werden.

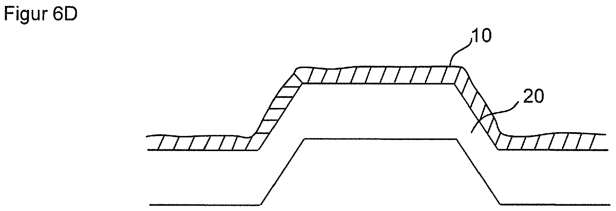

Figur 6D zeigt das Gehäuse 20 mit der darauf verpressten Folie 10 nach der Entnahme aus dem Formwerkzeug 100. Das Gehäuse 20 mit der darauf fixierten Folie 10 kann anschließend beispielsweise durch Verschrauben mit dem Gehäuse 30 an dem Gehäuse 30 befestigt werden, so dass die elektrische Einrichtung 40 vor elektrischer und/oder magnetischer Strahlung geschützt ist.

### Bezugszeichenliste

- 1: elektrische Vorrichtung
- 10: Folie
- 11: Klebstoffbeschichtung
- 12: Kunststoffbeschichtung
- 13: verpresste Falten in der Folie
- 20: Gehäuse aus elektrisch und/oder magnetisch nichtleitfähigem Material
- 21: äußere Wandung des Gehäuses
- 22: innere Wandung des Gehäuses
- 30: Gehäuse aus elektrisch und/oder magnetisch leitfähigem Material
- 40: elektrische Einrichtung/Hochvoltspeicher
- 50: Schraube
- 60: Buchse
- 100: Formwerkzeug
- 200: Formwerkzeug

## Patentansprüche

1. Verfahren zum Herstellen eines Gehäuses mit einer Schirmung vor elektrischer und/oder magnetischer Strahlung, umfassend:
- Bereitstellen einer elektrisch und/oder magnetisch leitfähigen Folie (10),
- Bereitstellen eines Gehäuses (20) aus einem elektrisch und/oder magnetisch nicht leitfähigem Material mit einer äußeren und einer inneren Wandung (21, 22),
- Bereitstellen eines Formwerkzeugs (100) mit einer Wandung (110), deren Form der inneren oder äußeren Wandung (21, 22) des Gehäuses (20) entspricht,
- Bereitstellen eines weiteren Formwerkzeugs (200), das zu der Wandung (110) des Formwerkzeugs (100) invers geformt ist,
- Pressen der Folie (10) an die Wandung (110) des Formwerkzeugs (100) durch Andrücken des weiteren Formwerkzeugs (200) gegen die Wandung (110) des Formwerkzeugs (100), wobei die Folie (10) zwischen dem Formwerkzeug (100) und dem weiteren Formwerkzeug (200) angeordnet ist,
- Formen der Folie (10) derart, dass eine Form der Folie (10) einer Form der äußeren oder inneren Wandung (21, 22) des Gehäuses (20) entspricht, indem die Folie in das Formwerkzeug (100) eingelegt und durch Andrücken der Folie (10) an die Wandung (110) des Formwerkzeugs (100) umgeformt wird,
- Anordnen der Folie (10) auf der inneren oder äußeren Wandung (21, 22) des Gehäuses (20).

2. Verfahren nach Anspruch 1, umfassend:
Nachführen der Folie (10) in das Formwerkzeug (100) während des Andrückens der Folie (10) an die Wandung (110) des Formwerkzeugs (100).

3. Verfahren nach einem der Ansprüche 1 oder 2, umfassend: Verpressen der Folie (10) an die Wandung (110) des Formwerkzeugs (100) derart, dass Falten (13) der Folie (10) glatt gepresst werden.

4. Verfahren nach einem der Ansprüche 1 bis 3, umfassend: Ansiegeln der umgeformten Folie (10) auf die äußere oder innere Wandung (21, 22) des Gehäuses (20).

5. Verfahren nach Anspruch 4, umfassend:
- Bereitstellen der Folie (10) vor dem Formen mit einer Kunststoffbeschichtung (12) auf einer Oberfläche der Folie,
- Heißsiegeln der geformten Folie (10) auf die äußere oder innere Wandung (21, 22) des Gehäuses (20) durch Erwärmen und Aufschmelzen der Kunststoffbeschichtung (12) und Verbinden der Kunststoffbeschichtung (12) mit der äußeren oder inneren Wandung (21, 22) des Gehäuses (20).

6. Verfahren nach einem der Ansprüche 1 bis 3, umfassend: Kleben der geformten Folie (10) auf die äußere oder innere Wandung (21, 22) des Gehäuses (20).

7. Verfahren nach einem der Ansprüche 1 bis 3, umfassend: Verschrauben der geformten Folie (10) an der äußeren oder inneren Wandung (21, 22) des Gehäuses (20).

8. Verfahren nach einem der Ansprüche 1 bis 3, umfassend:
- Erwärmen des Materials des Gehäuses (10),
- Pressen eines Materials des Gehäuses (20) auf die geformte Folie (10), wobei die geformte Folie (10) während des Pressvorgangs an der Wandung (110) des Formwerkzeugs (100) anliegt,
- Verbinden des Materials des Gehäuses (20) mit der geformten Folie (10) nach Erkalten des Materials des Gehäuses (20).

9. Verfahren nach einem der Ansprüche 1 bis 8,
- wobei die Folie (10) als eine Aluminium- oder Stahlblechfolie ausgebildet ist,
- wobei das Gehäuse (20) ein Material aus Kunststoff enthält.

10. Verfahren zum Herstellen eines Hochvoltspeichers mit einer Schirmung vor elektrischer und/oder magnetischer Strahlung, umfassend:
- Herstellen eines Gehäuses (20) mit einer Schirmung vor elektrischer und/oder magnetischer Strahlung nach einem der Ansprüche 1 bis 9,
- Bereitstellen eines weiteren Gehäuses (30) aus einem elektrisch und/oder magnetisch leitfähigen Material, wobei ein Ladungsspeicher (40) des Hochvoltspeichers von dem weiteren Gehäuse (30) umgeben ist,
- Anordnen des Gehäuses (20) als Deckel des Hochvoltspeichers auf dem weiteren Gehäuse (30).

11. Gehäuse mit Schirmung vor elektrischer und/oder magnetischer Strahlung, umfassend:
- eine elektrisch und/oder magnetisch leitfähige Folie (10),
- wobei das Gehäuse (20) aus einem elektrisch und/oder magnetisch nicht leitfähigem Material ausgebildet ist und eine äußere und innere Wandung (21, 22) aufweist,
- wobei die Folie (10) einer Form der äußeren oder inneren Wandung (21, 22) des Gehäuses (20) entspricht,
- wobei die Folie (10) auf der äußeren oder inneren Wandung (21, 22) des Gehäuses (20) angeordnet ist,
- wobei das Gehäuse (20) nach einem Verfahren der Ansprüche 1 bis 9 hergestellt ist.

12. Hochvoltspeicher mit Schirmung vor elektrischer und/oder magnetischer Strahlung, umfassend:
- ein Gehäuse (20) nach Anspruch 11,
- ein weiteres Gehäuse (30) aus einem elektrisch und/oder magnetisch leitfähigen Material,
- eine Ladungsspeicher (40),
- wobei der Ladungsspeicher (40) in dem weiteren Gehäuse (30) angeordnet ist,
- wobei das Gehäuse (20) an dem weiteren Gehäuse (30) derart angeordnet ist, dass der Ladungsspeicher (40) von dem Gehäuse (20) abgedeckt ist.

## Claims

1. A method for producing a housing with shielding from electric and/or magnetic radiation, comprising:
- supplying an electrically and/or magnetically conductive foil (10),
- supplying a housing (20) made of an electrically and/or magnetically non-conductive material, with an outer and an inner wall (21, 22),
- supplying a moulding tool (100), with a wall (110), the shape of which corresponds to the inner or outer wall (21, 22) of the housing (20),
- supplying a further moulding tool (200) which has an inverse shape to the wall (110) of the moulding tool (100),
- pressing the foil (10) against the wall (110) of the moulding tool (100) by pressing the further moulding tool (200) against the wall (110) of the moulding tool (100), wherein the foil (10) is arranged between the moulding tool (100) and the further moulding tool (200),
- shaping the foil (10) such that a shape of the foil (10) corresponds to a shape of the outer or inner wall (21, 22) of the housing (20), in that the foil is laid in the moulding tool (100) and is reshaped by pressing the foil (10) against the wall (110) of the moulding tool (100),
- arranging the foil (10) on the inner or outer wall (21, 22) of the housing (20).

2. A method according to Claim 1, comprising:
feeding the foil (10) into the moulding tool (100) while the foil (10) is being pressed against the wall (110) of the moulding tool (100).

3. A method according to one of Claims 1 or 2, comprising: pressing the foil (10) against the wall (110) of the moulding tool (100) such that folds (13) in the foil (10) are pressed smooth.

4. A method according to one of Claims 1 to 3, comprising: sealing the shaped foil (10) onto the outer or inner wall (21, 22) of the housing (20).

5. A method according to Claim 4, comprising:
- supplying the foil (10) prior to the shaping with a plastics-material coating (12) on one surface of the foil,
- hot-sealing the shaped foil (10) onto the outer or inner wall (21, 22) of the housing (20) by heating and melting the plastics-material coating (12) and joining the plastics-material coating (12) to the outer or inner wall (21, 22) of the housing (20).

6. A method according to one of Claims 1 to 3, comprising: adhesively bonding the shaped foil (10) onto the outer or inner wall (21, 22) of the housing (20).

7. A method according to one of Claims 1 to 3, comprising: screwing the shaped foil (10) to the outer or inner wall (21, 22) of the housing (20).

8. A method according to one of Claims 1 to 3, comprising:
- heating the material of the housing (10),
- pressing a material of the housing (20) against the shaped foil (10), wherein the shaped foil (10) lies against the wall (110) of the moulding tool (100) during the pressing operation,
- joining the material of the housing (20) with the shaped foil (10) once the material of the housing (20) has cooled.

9. A method according to one of Claims 1 to 8,
- wherein the foil (10) is formed as an aluminium or steel sheet foil,
- wherein the housing (20) contains a material consisting of plastics material.

10. A method for producing a high-voltage storage means with shielding from electric and/or magnetic radiation, comprising:
- producing a housing (20) with shielding from electric and/or magnetic radiation according to one of Claims 1 to 9,
- supplying a further housing (30) made of an electrically and/or magnetically conductive material, wherein a charge storage means (40) of the high-voltage storage means is surrounded by the further housing (30),
- arranging the housing (20) as a cover of the high-voltage storage means on the further housing (30).

11. A housing with shielding from electric and/or magnetic radiation, comprising:
- an electrically and/or magnetically conductive foil (10),
- wherein the housing (20) is formed from an electrically and/or magnetically non-conductive material and has an outer and inner wall (21, 22),
- wherein the foil (10) corresponds to a shape of the outer or inner wall (21, 22) of the housing (20),
- wherein the foil (10) is arranged on the outer or inner wall (21, 22) of the housing (20),
- wherein the housing (20) is produced according to a method of Claims 1 to 9.

12. A high-voltage storage means with shielding from electric and/or magnetic radiation, comprising:
- a housing (20) according to Claim 11,
- a further housing (30) made of an electrically and/or magnetically conductive material,
- a charge storage means (40),
- wherein the charge storage means (40) is arranged in the further housing (30),
- wherein the housing (20) is arranged on the further housing (30) such that the charge storage means (40) is covered by the housing (20).

## Revendications

1. Procédé pour fabriquer un boîtier équipé d'un blindage anti-rayonnement électrique et/ou magnétique, consistant à :
- fournir un film (10) électro-conducteur et/ou magnéto-conducteur,
- fournir un boîtier (20) en une matière non électro-conductrice et/ou non-magnéto-conductrice ayant une paroi extérieure et une paroi intérieure (21, 22),
- fournir un outil de moulage (100) comportant une paroi (110) dont la forme correspond à la paroi intérieure ou à la paroi extérieure (21, 22) du boîtier (20),
- fournir un autre outil de moulage (200) de forme inverse de celle de la paroi (110) de l'outil de moulage (100),
- presser le film (10) contre la paroi (110) de l'outil de moulage (100) en pressant l'autre outil de moulage (200) contre la paroi (110) de l'outil de moulage (100), le film (10) étant interposé entre l'outil de moulage (100) et l'autre outil de moulage (200),
- mettre en forme le film (10) pour que la forme du film (10) corresponde à la forme de la paroi extérieure ou de la paroi intérieure (21, 22) du boîtier (20) en ce que le film est placé dans l'outil de moulage (100) et mis en forme par l'application du film (10) contre la paroi (110) de l'outil de moulage (100),
- disposer le film (10) sur la paroi intérieure ou la paroi extérieure (21, 22) du boîtier (20).

2. Procédé selon la revendication 1,
consistant à :
suivre le guidage du film (10) dans l'outil de moulage (100) pendant que le film (10) est pressé contre la paroi (110) de l'outil de moulage (100).

3. Procédé selon l'une des revendications 1 ou 2,
consistant à :
presser le film (10) contre la paroi (110) de l'outil de moulage (100) pour aplatir par pressage les plis (13) du film (10).

4. Procédé selon l'une des revendications 1 à 3,
consistant à :
sceller le film mis en forme (10) à la paroi extérieure ou la paroi intérieure (21, 22) du boîtier (20).

5. Procédé selon la revendication 4,
consistant à :
- fournir le film (10) avant de le former avec un revêtement de matière plastique (12) sur la surface supérieure du film,
- sceller à chaud le film (10) mis en forme sur la paroi intérieure ou la paroi extérieure (21, 22) du boîtier (20) par chauffage et fusion du revêtement de matière plastique (12) et liaison du revêtement de matière plastique (12) à la paroi extérieure ou à la paroi intérieure (21, 22) du boîtier (20).

6. Procédé selon l'une des revendications 1 à 3,
consistant à :
coller le film mis en forme (10) sur la paroi extérieure ou la paroi intérieure (21, 22) du boîtier (20).

7. Procédé selon l'une des revendications 1 à 3,
consistant à :
visser le film mis en forme (10) à la paroi extérieure ou la paroi intérieure (21, 22) du boîtier (20).

8. Procédé selon l'une des revendications 1 à 3,
consistant à :
- chauffer la matière du boîtier (20),
- presser la matière du boîtier (20) sur le film (10) mis en forme, le film mis en forme (10) étant appliqué contre la paroi (110) de l'outil de moulage (100) pendant la phase de pressage,
- relier la matière du boîtier (20) au film (10) mis en forme après refroidissement de la matière du boîtier (20).

9. Procédé selon l'une des revendications 1 à 8,
selon lequel
- le film (10) est un film de tôle d'aluminium ou d'acier,
- le boîtier (20) est en un matériau contenant une matière plastique.

10. Procédé de fabrication d'un accumulateur de tension élevée avec un blindage anti-rayonnement électrique et/ou magnétique,
consistant à :
- fabriquer un boîtier (20) avec un blindage anti-rayonnement électrique et/ou magnétique selon l'une des revendications 1 à 9,
- fournir un autre boîtier (30) en une matière électro-conductrice et/ou magnéto-conductrice, l'accumulateur de charges (40) de l'accumulateur de haute tension étant entouré par cet autre boîtier (30),
- disposer le boîtier (20) comme couvercle de l'accumulateur haute tension sur l'autre boîtier (30).

11. Boîtier équipé d'un blindage anti-rayonnement électrique et/ou magnétique,
comprenant :
- un film (10) électro-conducteur et/ou magnéto-conducteur,
- le boîtier (20) est réalisé en une matière non électro-conductrice et/ou non-magnéto-conductrice et comprend une paroi extérieure et une paroi intérieure (21, 22),
- le film (10) correspond à la forme de la paroi extérieure ou de la paroi intérieure (21, 22) du boîtier (20),
- le film (10) est prévu sur la paroi extérieure ou la paroi intérieure (21, 22) du boîtier (20),
- le boîtier (20) est réalisé selon le procédé des revendications 1 à 9.

12. Accumulateur haute tension avec un blindage anti-rayonnement électrique et/ou magnétique,
comprenant :
- un boîtier (20) selon la revendication 11,
- un autre boîtier (30) en une matière électro-conductrice et/ou magnéto-conductrice,
- un accumulateur de charges (40),
- l'accumulateur de charges (40) étant dans l'autre boîtier (30),
- le boîtier (20) étant installé sur l'autre boîtier (30) pour que l'accumulateur de charges (40) soit couvert par le boîtier (20).
